# FASCICULE DE BREVET EUROPEEN

(11) **EP 3 002 999 B1**
(45) Date de publication et mention de la délivrance du brevet: **27.05.2020**
(21) Numéro de dépôt: 15185663.0
(22) Date de dépôt: 17.09.2015
(51) Int. Cl.: H05K 7/14, H05K 7/20

(54) **DISPOSITIF ELECTRIQUE MODULAIRE OU CHAQUE MODULE EST DESTINE A ETRE FIXE A UN SUPPORT RESPECTIF, ET SYSTEME ELECTRIQUE COMPORTANT UN TEL DISPOSITIF ELECTRIQUE**
MODULARE ELEKTRISCHE VORRICHTUNG, BEI DER JEDES MODUL AUF EINER ENTSPRECHENDEN HALTERUNG BEFESTIGT WIRD, UND ELEKTRISCHES SYSTEM, DAS EINE SOLCHE ELEKTRISCHE VORRICHTUNG UMFASST
MODULAR ELECTRICAL DEVICE IN WHICH EACH MODULE IS INTENDED FOR BEING SECURED TO A RESPECTIVE MOUNTING, AND ELECTRICAL SYSTEM COMPRISING SUCH AN ELECTRICAL DEVICE

(30) Priorité: 30.09.2014 FR 1459316
(43) Date de publication de la demande: 06.04.2016
(73) Titulaire: Valeo Siemens eAutomotive France SAS, 95800 Cergy (FR)
(72) Inventeur: TRAMET, Guillaume, 78360 MONTESSON (FR); COLONGES, Jean-Baptiste, 01240 DOMPIERRE SUR VEYLE (FR)
(74) Mandataire: Argyma

(56) Documents cités:
- DE-A1-102007 043 536
- FR-A1- 2 986 666
- US-A- 5 675 223
- US-A1- 2007 247 823
- US-A1- 2012 044 640

## Description

### DOMAINE TECHNIQUE

La présente invention concerne le domaine des systèmes électriques, en particulier destinés à être intercalés entre une batterie et un moteur électrique d'un véhicule automobile.

### ARRIÈRE-PLAN TECHNOLOGIQUE

Il est connu d'utiliser un dispositif électrique ayant des parties, appelées modules, destinées à réaliser chacune une fonction prédéfinie tout en étant connectées électriquement entre elles.

Il est généralement nécessaire de fixer chaque module du dispositif électrique à une plaque froide pour évacuer la chaleur dégagée par ce module. Un tel dispositif est connu de DE 10 2007 043 536 A1.

Or, du fait de cette construction modulaire, des jeux importants peuvent apparaitre de sorte que lorsqu'un module est fixé à une partie de plaque froide formant support pour ce premier module, l'autre module n'est pas correctement positionné au contact d'une autre partie de plaque froide formant support pour cet autre module. Ainsi, lors de la fixation de l'autre module, le boîtier du dispositif électrique est déformé et des contraintes sont imposées aux éléments que le boîtier contient, et en particulier, le cas échéant, aux cartes électroniques que le boîtier contient. En outre, le contact avec la ou les plaques froides risque d'être imparfait, de sorte que la chaleur est mal évacuée.

L'invention a pour but de remédier au moins en partie aux problèmes précédents.

### RÉSUMÉ DE L'INVENTION

À cet effet, il est proposé un dispositif électrique comportant :
- un module principal destiné à être fixé à un premier support,
- un module auxiliaire connecté électriquement au module principal et destiné à être fixé à un second support,
- au moins une attache attachant le module auxiliaire au module principal afin d'empêcher le module auxiliaire de se détacher du module principal, la ou les attaches permettant un débattement du module auxiliaire par rapport au module principal, uniquement selon une direction avant-arrière, entre une position proche et une position éloignée du module principal.

Grâce à l'invention, il est possible d'ajuster la position du module auxiliaire par rapport au module principal, de sorte que les deux modules peuvent être correctement positionnés au contact de leurs supports respectifs. Ainsi, les contraintes sur le dispositif électrique sont diminuées et la durée de vie du dispositif électronique est améliorée. En outre, le contact des modules avec leurs supports respectifs est amélioré, de sorte qu'une meilleure conduction thermique peut être obtenue lorsque les supports sont des parties de plaque froide.

De façon optionnelle, le débattement est d'au moins 0,5 mm.

De façon optionnelle également, le débattement est d'au plus 10 mm.

De façon optionnelle également, le module principal présente une face arrière, appelée face arrière principale, destinée à être plaquée contre une partie d'une plaque froide formant le premier support, le module auxiliaire présente une face arrière, appelée face arrière auxiliaire, destinée à être plaquée contre une autre partie de la plaque froide formant le second support, et la face arrière auxiliaire s'étend à l'arrière de la face arrière principale lorsque le module auxiliaire est dans une position intermédiaire, à mi-chemin des positions proche et éloignée du module principal.

De façon optionnelle également, la face arrière auxiliaire s'étend à l'arrière de la face arrière principale d'une distance comprise entre 5 mm et 20 mm lorsque le module auxiliaire est dans la position intermédiaire.

De façon optionnelle également, le module principal comporte un boîtier dans lequel des ouvertures d'entrée d'air sont ménagées, et le dispositif électrique comporte en outre des vis de fixation du module principal et du module auxiliaire à leurs supports respectifs, ces vis présentant une tête plus grande que les ouvertures d'entrée d'air.

De façon optionnelle également, le module principal est destiné à fournir de l'électricité, appelée électricité d'entraînement, à des phases d'un moteur électrique à partir d'électricité fournie par une batterie, et le module auxiliaire est destiné à fournir de l'électricité, appelée électricité d'excitation, à un rotor du moteur électrique à partir de l'électricité fournie par la batterie.

De façon optionnelle également, le module principal comporte un boîtier principal, le module auxiliaire comporte un boîtier auxiliaire et la ou les attaches sont portées par le boîtier principal et le boîtier auxiliaire de manière à attacher le boîtier auxiliaire au boîtier principal.

Notamment, la ou les attaches permettent un débattement du module auxiliaire par rapport au module principal, uniquement selon la direction avant-arrière, entre une position proche et une position éloignée du module principal. Ainsi, le débattement entre le module principal et le module auxiliaire est contraint suivant ladite direction avant-arrière. En particulier, ladite direction avant-arrière est une direction rectiligne.

Il est en outre proposé un système électrique comportant :
- un dispositif électrique selon l'invention,
- une plaque froide présentant un palier en retrait et un palier avancé, s'étendant à l'avant du palier en retrait, les deux paliers étant reliés l'un à l'autre par une marche,
et dans lequel le module principal est fixé au palier avancé formant le premier support et dans lequel le module auxiliaire est fixé au palier en retrait formant le second support.

De façon optionnelle, la marche présente une hauteur dans la direction avant-arrière comprise entre 5 mm et 20 mm.

De façon optionnelle également, le système électrique comporte un système de refroidissement destiné à faire circuler, sous le palier avancé, un liquide de refroidissement.

### DESCRIPTION DES FIGURES

Un mode de réalisation de l'invention va à présent être décrit à titre d'exemple uniquement, en référence aux figures suivantes.
La figure 1 est une vue simplifiée d'un système électrique selon l'invention.
La figure 2 est une vue fonctionnelle d'un dispositif électrique du système électrique de la figure 1.
Les figures 3, 4 et 5 sont des vues en trois dimensions du dispositif électrique de la figure 2.
La figure 6 est une vue éclatée en trois dimensions du dispositif de la figure 2.

### DESCRIPTION DÉTAILLÉE

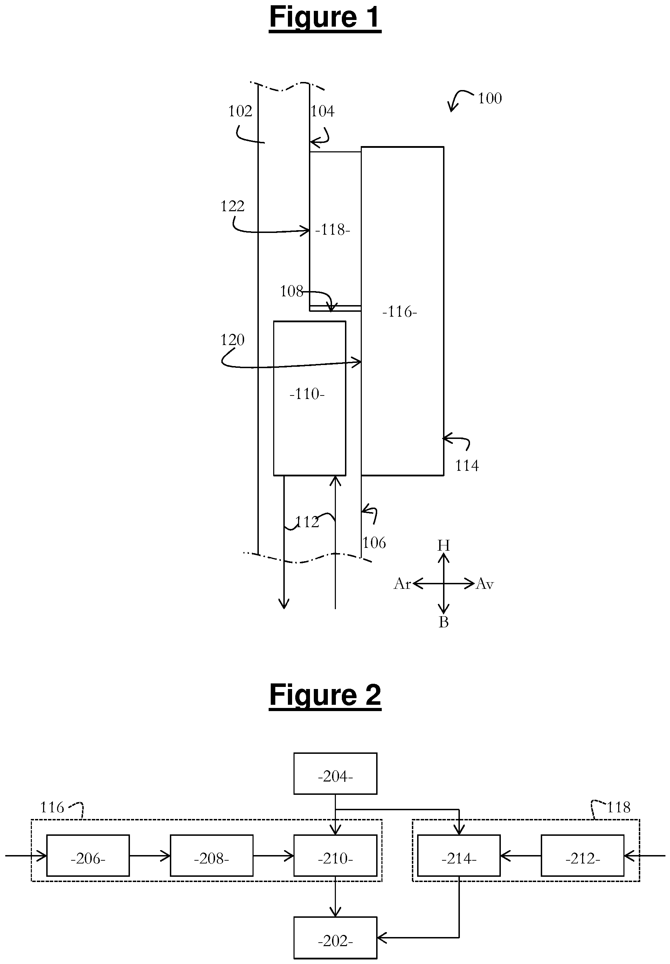

En référence aux figures 1 à 6, un système électrique, notamment destiné à connecter une batterie d'un véhicule automobile à un moteur électrique de ce véhicule automobile, va être décrit. Le système électrique sera désigné par la suite par la référence générale 100. En outre, les éléments du système électrique 100 seront décrits en référence à un repère orthonormé arbitraire comportant les directions : bas-haut B-H, droite-gauche D-G et avant-arrière Av-Ar.

En référence à la figure 1, le système électrique 100 comporte tout d'abord une plaque froide 102 s'étendant sensiblement dans le plan défini par les directions bas-haut B-H et droite-gauche D-G. La plaque froide 102 présente un palier en retrait 104 et un palier avancé 106, s'étendant à l'avant du palier en retrait 104. Les deux paliers 104, 106 sont reliés l'un à l'autre par une marche 108 présentant une hauteur dans la direction avant-arrière Av-A comprise entre 5 mm et 20 mm.

Le système électrique 100 comporte en outre un système de refroidissement 110 destiné à faire circuler, sous le palier avancé 106, un liquide de refroidissement représenté par les deux flèches 112. En revanche, aucune circulation de liquide de refroidissement n'est prévue sous le palier en retrait 104.

Ainsi, grâce à la marche 108 et aux paliers 104, 106, l'épaisseur de la plaque froide 102 est plus faible sous le palier en retrait 104 que sous le palier avancé 106. Cela permet un gain de place en face du palier en retrait 104, ainsi qu'un gain de matière pour fabriquer la plaque froide 102, tout en laissant une épaisseur de plaque froide suffisante pour le système de refroidissement 110.

Le système électrique 100 comporte en outre un dispositif électrique 114 fixé à la plaque froide 102.

Plus précisément, le dispositif électrique 114 comporte un module principal 116 et un module auxiliaire 118 attaché au module principal 116. Le module auxiliaire 118 se projette vers l'arrière du module principal 116, à partir d'une partie haute du module principal 116. Le module principal 116 présente, sous le module auxiliaire 118, une face arrière, appelée face arrière principale 120, plaquée contre le palier avancé 106 et fixée à ce dernier. Le module auxiliaire 118 présente également une face arrière, appelée face arrière auxiliaire 122, plaquée contre le palier en retrait 104 et fixée à ce dernier.

Le module auxiliaire 118 est destiné à pouvoir se débattre, au moins selon la direction avant-arrière Av-Ar, entre une position proche et une position éloignée du module principal 116. Le débattement du module auxiliaire 118, c'est-à-dire la distance selon la direction avant-arrière Av-Ar sur laquelle le module auxiliaire 118 peut se déplacer par rapport au module principal 116, est de préférence compris entre 0,5 mm et 10 mm.

Par ailleurs, lorsque le module auxiliaire 118 est dans une position intermédiaire, à mi-chemin des positions proche et éloignées du module principal 116, la face arrière auxiliaire 122 s'étend à l'arrière de la face arrière principale 120, par exemple d'une distance comprise entre 5 mm et 20 mm.

De préférence, la face arrière auxiliaire 122 s'étend à l'arrière de la face arrière principale 120 sur tout le débattement du module auxiliaire 118.

Ainsi, le fait que la face arrière auxiliaire 122 s'étende à l'arrière de la face arrière principale 120 permet de fixer le dispositif électrique 114 sur une plaque froide présentant une marche reliant deux paliers, telle que la plaque froide 102.

En référence à la figure 2, les modules principal 116 et auxiliaire 118 vont à présent être décrits fonctionnellement.

Le module principal 116 est destiné à fournir de l'électricité, appelée électricité d'entrainement, à des phases (non représentées) d'un moteur électrique 202 du véhicule automobile à partir d'électricité fournie par une batterie 204 de ce véhicule automobile. Les phases ainsi alimentées sont destinées à entraîner en rotation un rotor (non représenté) du moteur électrique 202.

Ainsi, le module principal 116 comporte une première partie, appelée partie de commande d'entraînement 206, destinée à fournir un signal de commande à partir d'informations reçues, par exemple d'un calculateur (non représenté) du véhicule automobile. Le signal de commande représente par exemple un couple moteur souhaité pour le véhicule automobile.

Le module principal 116 comporte en outre une seconde partie, appelée partie de pilotage d'entraînement 208, destinée à fournir un signal de pilotage à partir du signal de commande reçu de la partie de commande d'entraînement 206. La partie de pilotage d'entraînement 208 est généralement appelée « driver » en anglais.

Le module principal 116 comporte en outre un premier convertisseur électrique, appelé convertisseur électrique d'entraînement 210, destiné à convertir l'électricité fournie par la batterie 204 en électricité d'entraînement. Dans l'exemple décrit, le convertisseur électrique d'entraînement 210 est un onduleur destiné à convertir la tension électrique continue fournie par la batterie 204 en courant alternatif triphasé destiné aux phases du moteur électrique 202. À cet effet, le convertisseur électrique d'entrainement 210 comporte des interrupteurs commandés (non représentés), tels que des IGBT, pilotés par le signal de pilotage reçu de la partie de pilotage d'entraînement 208. Par exemple, le convertisseur électrique d'entraînement 210 comporte six interrupteurs commandés.

Le module auxiliaire 118 est destiné à fournir de l'électricité, appelée électricité d'excitation, au rotor du moteur électrique 202 à partir de l'électricité fournie par la batterie 204. L'électricité d'excitation est destinée à exciter le rotor pour le polariser afin qu'il puisse être entraîné par les phases du moteur électrique 202.

Ainsi, le module auxiliaire 118 comporte tout d'abord une partie, appelée partie de pilotage d'excitation 212, destinée à fournir un signal de pilotage en fonction d'informations reçues, par exemple du calculateur du véhicule automobile.

Le module auxiliaire 118 comporte en outre un convertisseur électrique, appelé convertisseur électrique d'excitation 214, destiné à convertir l'électricité fournie par la batterie 204 en électricité destinée au rotor du moteur électrique 202. Dans l'exemple décrit, le convertisseur électrique d'excitation 214 est destiné à convertir la tension continue, généralement autour de 400 V, fournie par la batterie 204 en courant continu, valant généralement jusqu'à 16 A, destiné au rotor. À cet effet, le convertisseur électrique d'excitation 214 comporte des interrupteurs commandés (non représentés), tels que des IGBT, pilotés par le signal de pilotage reçu de la partie de pilotage d'excitation 212. Le convertisseur électrique d'excitation 214 comporte par exemple deux interrupteurs commandés.

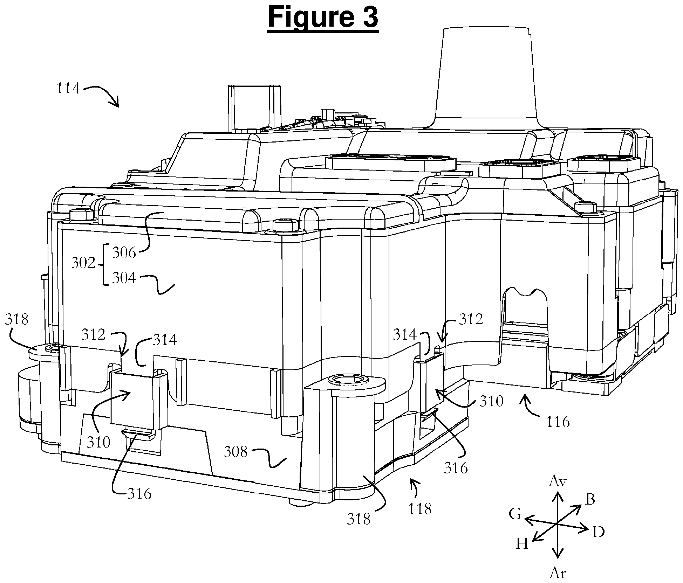

En référence à la figure 3, le module principal 116 comporte un boîtier principal 302 comportant un corps 304 définissant des parois latérales autour de la direction avant-arrière Av-Ar et un couvercle 306 destiné à recouvrir le corps 304 pour fermer le boîtier principal 302 vers l'avant.

Le module auxiliaire 118 comporte un boîtier auxiliaire 308 définissant des parois latérales autour de la direction avant-arrière Av-Ar.

Par ailleurs, le dispositif électrique 114 comporte des attaches 310 attachant le module auxiliaire 118 au module principal 116 afin d'empêcher le module auxiliaire 118 de se détacher du module principal 116. Les attaches 310 permettent le débattement évoqué précédemment du module auxiliaire 118 par rapport au module principal 116, entre la position proche et la position éloignée du module principal 116.

Dans l'exemple décrit, les attaches 310 sont destinées à clipper le module auxiliaire 118 au module principal 116. Plus précisément, chaque attache 310 comporte une fente 312 définie par le boîtier auxiliaire 308 et une languette 314 portée par le boîtier principal 302 et insérée dans la fente 312. La languette 314 est destinée à glisser dans la fente 312 de manière à permettre le débattement. La languette 314 présente en outre une extrémité libre 316 dépassant de la fente 312. L'extrémité libre 316 est plus large que la fente 312 de manière à empêcher la languette 314 de sortir de la fente 312, et de ce fait empêcher le module auxiliaire 118 de se détacher du module principal 116. En outre, l'extrémité libre 316 est biseautée de manière à permettre l'insertion de la languette 314 dans la fente 312.

Par ailleurs, le module auxiliaire 118 comporte des fixations, appelées fixations auxiliaires 318, pour fixer le module auxiliaire 118 au palier en retrait 104 de la plaque froide 102. Dans l'exemple décrit, les fixations auxiliaires 318 comportent chacune un passage de vis s'étendant dans la direction avant-arrière Av-Ar.

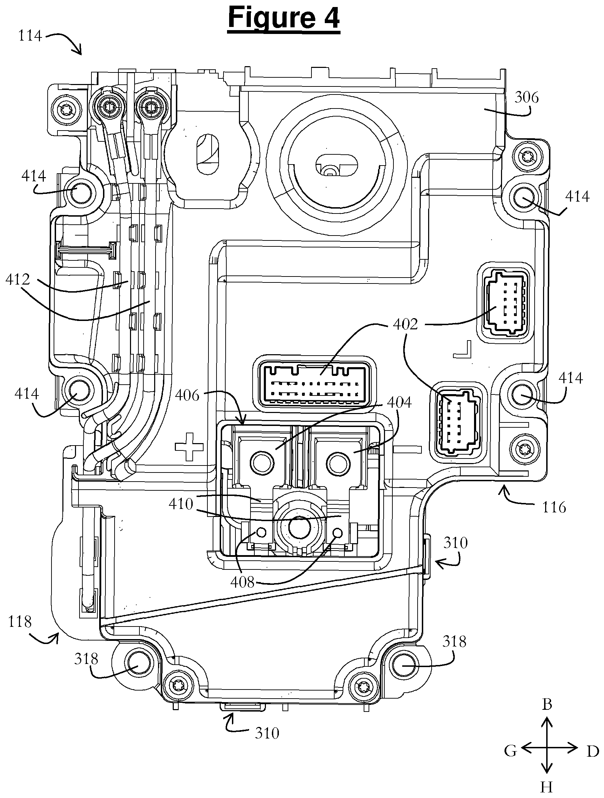

En référence à la figure 4, le module principal 116 du dispositif électrique 114 comporte, à l'avant, s'étendant au travers du couvercle 306, des connecteurs externes 402 auxquels des câbles de transport d'information sont destinés à être connectés pour fournir des informations à la partie de commande d'entraînement 206 du module principal 116 et à la partie de pilotage d'excitation 212 du module auxiliaire.

Le module principal 116 du dispositif électrique 114 comporte en outre, dans le boîtier principal 302, des bornes d'entrée principales 404 destinées à être connectées à la batterie 204 par des câbles électriques.

Les bornes d'entrée principales 404 sont accessibles par une ouverture avant 406 ménagée dans le couvercle 306. L'ouverture avant 406 est en outre destinée à permettre la sortie d'air chaud hors du boîtier principal 302.

Afin d'être connecté à la batterie 204, le module auxiliaire 118 comporte également des bornes d'entrée auxiliaires 408.

Le dispositif électronique 114 comporte en outre des interconnexions électriques souples, appelées interconnexions électriques d'entrée 410, connectant les bornes d'entrée principales 404 aux bornes d'entrée auxiliaires 408, tout en permettant le déplacement du module auxiliaire 118 par rapport au module principal 116. Dans l'exemple décrit, les interconnexions électriques d'entrée 410 comportent des languettes flexibles reliant chacune une borne d'entrée principale 404 à une borne d'entrée auxiliaire 408.

Le dispositif électrique 114 comporte en outre des câbles électriques, appelés câbles électriques de sortie d'excitation 412, s'étendant au moins en partie à l'extérieur du boîtier principal 302 et destinés à convoyer l'électricité d'excitation depuis le module auxiliaire 118 vers des bornes de sortie d'excitation (non visibles sur la figure 4) situées en bas du module principal 116. Ces bornes de sortie d'excitation seront décrites plus en détail par la suite.

Le module principal 116 comporte en outre des fixations, appelées fixations principales 414, pour fixer le module principal 116 au palier avancé 106 de la plaque froide 102. Dans l'exemple décrit, les fixations principales 414 comportent chacune un passage de vis s'étendant dans la direction avant-arrière Av-Ar.

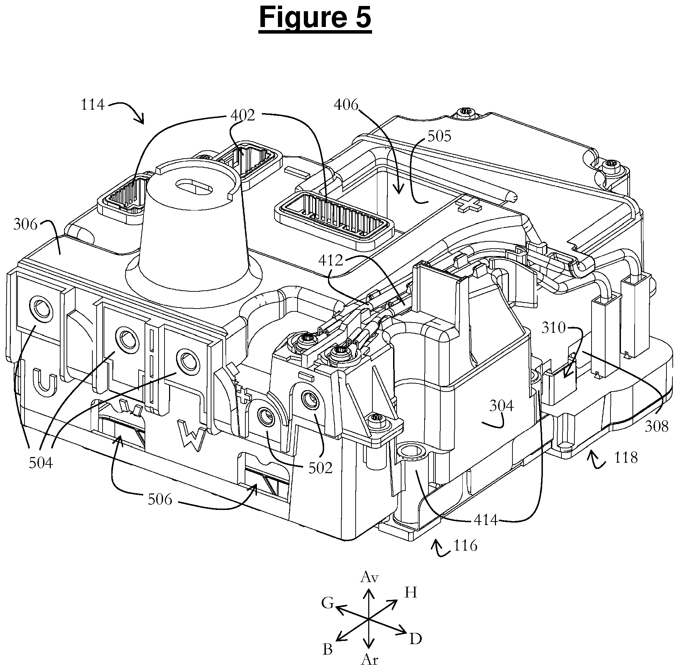

En référence à la figure 5, le module principal 116 comporte, en bas, des premières bornes de sortie, appelées bornes de sortie d'excitation 502, auxquelles les câbles électriques 412 sont reliés de sorte que les bornes de sortie d'excitation 502 fournissent l'électricité d'excitation pour le rotor du moteur électrique 202.

Le module principal 116 comporte en outre des secondes bornes de sortie, appelées bornes de sortie d'entraînement 504, destinées à fournir l'électricité d'entraînement pour les phases du moteur électrique 202.

Par ailleurs, des parois internes du corps 304 du boîtier principal 302 définissent un puits 505 reliant l'ouverture avant 406 au bornes d'entrée principales 404, ces dernières étant disposées au fond du puits 505. Des ouvertures de passage d'air (non représentées) sont ménagées dans le puit 505.

Par ailleurs, des ouvertures d'entrée d'air 506 sont ménagées en bas du corps 304 du boîtier principal 302, et en particulier plus bas que l'ouverture avant 406. Ainsi, de l'air frais peut entrer par les ouvertures d'entrée d'air 506, capter de la chaleur dans le module principal 116 et remonter dans le module principal 116 pour entrer dans le puits 505 au travers des ouvertures qui y sont ménagées et sortir du boîtier principal 302 par l'ouverture avant 406.

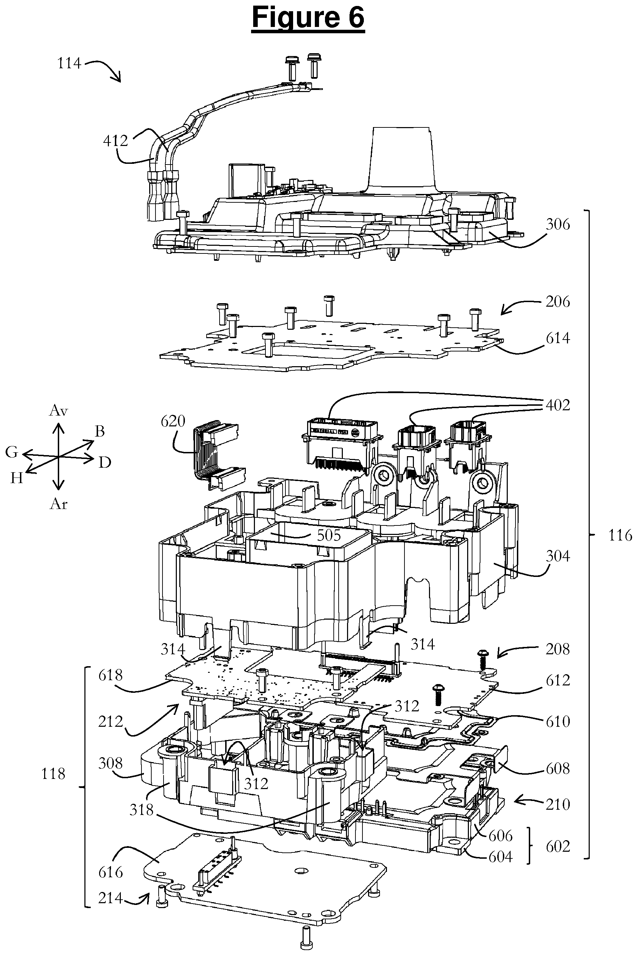

En référence à la figure 6, le convertisseur électrique d'entraînement 210 du module principal 116 comporte un module électrique de puissance 602. Le module électrique de puissance 602 comporte une plaque de base 604 recouverte à l'avant d'un boîtier 606 dans lequel se trouvent les interrupteurs commandés. La plaque de base 604 est destinée à être plaquée contre le palier avancé 106 de la plaque froide 102 et définit de ce fait la face arrière principale 120 du module principal 116. La plaque de base 604 forme une masse électrique du module électrique de puissance 602, ainsi qu'un conducteur thermique permettant à la chaleur générée par le module électrique de puissance 602 de s'échapper en direction de la plaque froide 102.

Le module principal 116 comporte en outre un blindage électromagnétique 608 recouvrant à l'avant le module électrique de puissance 602.

Le module principal 116 comporte en outre une feuille d'isolation électromagnétique 610 recouvrant à l'avant le blindage électromagnétique 608.

La partie de pilotage d'entraînement 208 du module principal 116 comporte en outre une première carte électronique 612 s'étendant à l'avant de la feuille d'isolation 610.

Grâce à la feuille d'isolation 610, les perturbations électromagnétiques entre la première carte électronique 612 et le module électrique de puissance 602 sont diminuées.

La partie de commande d'entraînement 206 du module principal 116 comporte en outre une seconde carte électronique 614 s'étendant à l'avant de la première carte électronique 612.

Les éléments 602, 608, 610, 612 et 614 sont disposés dans le boîtier principal 302 et fixés à ce dernier, par exemple au moyen de vis.

Par ailleurs, le convertisseur électrique d'excitation 214 du module auxiliaire 118 comporte une troisième carte électronique 616 destinée à être plaquée contre le palier en retrait 104 de la plaque froide 102. Ainsi, la troisième carte électronique 616 définit la face arrière auxiliaire 122 du module auxiliaire 118.

La partie de pilotage d'excitation 212 du module auxiliaire 118 comporte une quatrième carte électronique 618 s'étendant à l'avant de la troisième carte électronique 616.

Les troisième et quatrième cartes électroniques 616, 618 sont disposées dans le boîtier auxiliaire 308 et fixées à ce dernier, par exemple au moyen de vis.

Le dispositif électrique 114 comporte en outre une connexion souple 620 connectant la deuxième carte électronique 614 à la quatrième carte électronique 618 malgré le déplacement du module auxiliaire 118 par rapport au module principal 116. La connexion souple 620 comporte par exemple une nappe.

L'assemblage et le fonctionnement du système électrique 100 va à présent être décrit.

Tout d'abord, le dispositif électrique 114 est fourni avec les modules principal 116 et auxiliaire 118 montés et avec le module auxiliaire 118 attaché au module principal par les attaches 310.

Le dispositif électrique 114 est alors disposé contre la plaque froide 102, avec le module principal 116 plaqué contre le palier avancé 106.

À cause des jeux inhérents à la fabrication du dispositif électrique 114, il peut arriver que la face arrière auxiliaire 122 du module auxiliaire 118 soit décalée par rapport au palier en retrait 104 de la plaque froide 102. Cependant, grâce au débattement autorisé par les attaches 310, le module auxiliaire 118 est déplacé par rapport au module principal 116 pour plaquer la face arrière auxiliaire 122 contre le palier en retrait 104.

Des vis de fixation sont alors insérées dans les fixations principales 414 et auxiliaires 318 et vissées dans la plaque froide 102 pour fixer le dispositif électrique 114. De préférence, les vis de fixation présentent des têtes dont le diamètre est supérieur aux ouvertures d'entrée d'air 506 pour éviter qu'elles n'entrent dans le boîtier principal 302 par inadvertance par ces ouvertures.

Lors du fonctionnement du dispositif électrique 114, le module électrique de puissance 602 dégage beaucoup de chaleur qui est évacuée grâce à la présence du système de refroidissement 110 sous le palier avancé 106.

Le système de refroidissement 110 refroidit en outre incidemment le palier en retrait 104 de manière que la chaleur générée par le module auxiliaire 118, qui est moindre que celle générée par le module principal 116, peut être évacuée par le palier en retrait 104 de la plaque froide 102.

Par ailleurs, de l'air frais entre dans le boîtier principal 302 par les ouvertures d'entrée d'air 506 et ressort chauffé, plus haut, par l'ouverture avant 406.

Comme cela est apparent à la lecture de la description précédente, un dispositif électrique selon l'invention présent plusieurs avantages. Tout d'abord, il peut être fixé à une plaque froide présentant une marche. Un autre avantage est de pouvoir compenser les jeux de fabrication du dispositif électrique pour pouvoir plaquer le module principal et le module auxiliaire contre la plaque froide.

La présente invention n'est pas limitée au mode de réalisation décrit précédemment, mais est au contraire définie par les revendications qui suivent. Il sera en effet apparent à l'homme du métier que des modifications peuvent y être apportées.

**LISTE DES RÉFÉRENCES**

| | |
|---|---|
| Système électrique | 100 |
| Plaque froide | 102 |
| Palier en retrait | 104 |
| Palier avancé | 106 |
| Marche | 108 |
| Système de refroidissement | 110 |
| Liquide de refroidissement | 112 |
| Dispositif électrique | 114 |
| Module principal | 116 |
| Module auxiliaire | 118 |
| Face arrière principale | 120 |
| Face arrière auxiliaire | 122 |
| | |
| Moteur électrique | 202 |
| Batterie | 204 |
| Partie de commande d'entraînement | 206 |
| Partie de pilotage d'entraînement | 208 |
| Convertisseur électrique d'entraînement | 210 |
| Partie de pilotage d'excitation | 212 |
| Convertisseur électrique d'excitation | 214 |
| | |
| Boîtier principal | 302 |
| Corps du boîtier principal | 304 |
| Couvercle du boîtier principal | 306 |
| Boîtier auxiliaire | 308 |
| Attaches | 310 |
| Fentes | 312 |
| Languettes | 314 |
| Extrémités libres | 316 |
| Fixations auxiliaires | 318 |
| Connecteurs externes | 402 |
| Bornes d'entrée principales | 404 |
| Ouverture avant | 406 |
| Bornes d'entrée auxiliaires | 408 |
| Interconnexions électrique d'entrée | 410 |
| Câbles de sortie d'excitation | 412 |
| Fixations principales | 414 |
| | |
| Bornes de sortie d'excitation | 502 |
| Bornes de sortie d'entraînement | 504 |
| Puits | 505 |
| Ouvertures d'entrée d'air | 506 |
| | |
| Module électrique de puissance | 602 |
| Plaque de base | 604 |
| Boîtier | 606 |
| Blindage électromagnétique | 608 |
| Isolation électromagnétique | 610 |
| Première carte électronique | 612 |
| Deuxième carte électronique | 614 |
| Troisième carte électronique | 616 |
| Quatrième carte électronique | 618 |
| Connexion souple | 620 |

## Revendications

1. Dispositif électrique (114) comportant :
- un module principal (116) destiné à être fixé à un premier support (120),
- un module auxiliaire (118) connecté électriquement au module principal (116) et destiné à être fixé à un second support (122),
- au moins une attache (310) attachant le module auxiliaire (118) au module principal (116) afin d'empêcher le module auxiliaire (118) de se détacher du module principal (116), la ou les attaches (310) permettant un débattement du module auxiliaire (118) par rapport au module principal (116), uniquement selon une direction avant-arrière (Av-Ar), entre une position proche et une position éloignée du module principal (116).

2. Dispositif électrique (114) selon la revendication 1, dans lequel le débattement est d'au moins 0,5 mm.

3. Dispositif électrique (114) selon la revendication 1 ou 2, dans lequel le débattement est d'au plus 10 mm.

4. Dispositif électrique (114) selon l'une quelconque des revendications 1 à 3, dans lequel le module principal (116) présente une face arrière, appelée face arrière principale (120), destinée à être plaquée contre une partie (120) d'une plaque froide (102) formant le premier support, dans lequel le module auxiliaire (118) présente une face arrière, appelée face arrière auxiliaire (122), destinée à être plaquée contre une autre partie (122) de la plaque froide (102) formant le second support, et dans lequel la face arrière auxiliaire (122) s'étend à l'arrière de la face arrière principale (120) sur tout le débattement du module auxiliaire (118).

5. Dispositif électrique (114) selon la revendication 4, dans lequel la face arrière auxiliaire (122) s'étend à l'arrière de la face arrière principale (120) d'une distance comprise entre 5 mm et 20 mm lorsque le module auxiliaire (118) est dans une position intermédiaire, à mi-chemin des positions proche et éloignée du module principal (116).

6. Dispositif électrique selon l'une quelconque des revendications 1 à 5, dans lequel le module principal (116) comporte un boîtier (302) dans lequel des ouvertures d'entrée d'air (506) sont ménagées, et comportant en outre des vis de fixation du module principal (116) et du module auxiliaire (118) à leurs supports respectifs, ces vis présentant une tête plus grande que les ouvertures d'entrée d'air (506).

7. Dispositif électrique (114) selon l'une quelconque des revendications 1 à 6, dans lequel le module principal (116) est destiné à fournir de l'électricité, appelée électricité d'entraînement, à des phases d'un moteur électrique (202) à partir d'électricité fournie par une batterie (204), et dans lequel le module auxiliaire (118) est destiné à fournir de l'électricité, appelée électricité d'excitation, à un rotor du moteur électrique (202) à partir de l'électricité fournie par la batterie (204).

8. Dispositif électrique (114) selon l'une quelconque des revendications 1 à 7, dans lequel le module principal (116) comporte un boîtier principal (302), et le module auxiliaire (118) comporte un boîtier auxiliaire (308) et dans lequel la ou les attaches (310) sont portées par le boîtier principal (302) et le boîtier auxiliaire (308) de manière à attacher le boîtier auxiliaire (308) au boîtier principal (302).

9. Système électrique (100) comportant :
- un dispositif électrique (114) selon l'une quelconque des revendications 1 à 8,
- une plaque froide (102) présentant un palier en retrait (104) et un palier avancé (106), s'étendant à l'avant du palier en retrait (104), les deux paliers (104, 106) étant reliés l'un à l'autre par une marche (108),
dans lequel le module principal (116) est fixé au palier avancé (106) formant le premier support et dans lequel le module auxiliaire (118) est fixé au palier en retrait (104) formant le second support.

10. Système électrique (100) selon la revendication 9, dans lequel la marche (108) présente une hauteur dans la direction avant-arrière (Av-Ar) comprise entre 5 mm et 20 mm.

11. Système électrique (100) selon la revendication 9 ou 10, comportant un système de refroidissement (110) destiné à faire circuler, sous le palier avancé (106), un liquide de refroidissement.

## Patentansprüche

1. Elektrische Vorrichtung (114), aufweisend:
- ein Hauptmodul (116), das zur Befestigung an einem ersten Halter (120) bestimmt ist,
- ein Hilfsmodul (118), das mit dem Hauptmodul (116) elektrisch verbunden ist und zur Befestigung an einem zweiten Halter (122) bestimmt ist,
- mindestens eine Halterung (310), die das Hilfsmodul (118) am Hauptmodul (116) festmacht, um zu vermeiden, dass sich das Hilfsmodul (118) vom Hauptmodul (116) löst, wobei die Halterung(en) (310) einen Ausschlag des Hilfsmoduls (118) in Bezug auf das Hauptmodul (116) nur gemäß einer Vorn-Hinten-Richtung (Av-Ar) zwischen einer nahen Position zum und einer entfernten Position vom Hauptmodul (116) erlaubt/erlauben.

2. Elektrische Vorrichtung (114) nach Anspruch 1, wobei der Ausschlag mindestens 0,5 mm beträgt.

3. Elektrische Vorrichtung (114) nach Anspruch 1 oder 2, wobei der Ausschlag höchstens 10 mm beträgt.

4. Elektrische Vorrichtung (114) nach einem der Ansprüche 1 bis 3, wobei das Hauptmodul (116) eine Rückseite, bezeichnet als Haupt-Rückseite (120), aufweist, die bestimmt ist, an einem Abschnitt (120) einer Kühlplatte (102) anzuliegen, die den ersten Halter bildet, wobei das Hilfsmodul (118) eine Rückseite, bezeichnet als Hilfs-Rückseite (122), aufweist, die bestimmt ist, an einem anderen Abschnitt (122) der Kühlplatte (102) anzuliegen, die den zweiten Halter bildet, und wobei sich die Hilfs-Rückseite (122) hinter der Haupt-Rückseite (120) über den gesamten Ausschlag des Hilfsmoduls (118) erstreckt.

5. Elektrische Vorrichtung (114) nach Anspruch 4, wobei sich die Hilfs-Rückseite (122) hinter der Haupt-Rückseite (120) in einem Abstand erstreckt, der zwischen 5 mm und 20 mm beträgt, wenn das Hilfsmodul (118) in einer Übergangsposition auf halbem Weg von der nahen und entfernten Position des Hauptmoduls (116) ist.

6. Elektrische Vorrichtung (114) nach einem der Ansprüche 1 bis 5, wobei das Hauptmodul (116) ein Gehäuse (302) aufweist, in welchem Lufteinlassöffnungen (506) ausgebildet sind, und aufweisend ferner Befestigungsschrauben des Hauptmoduls (116) und des Hilfsmoduls (118) an ihren jeweiligen Haltern, wobei diese Schrauben einen größeren Kopf als die Lufteinlassöffnungen (506) aufweisen.

7. Elektrische Vorrichtung (114) nach einem der Ansprüche 1 bis 6, wobei das Hauptmodul (116) zur Bereitstellung von Elektrizität, bezeichnet als Antriebselektrizität, für Phasen eines Elektromotors (202) auf der Basis von Elektrizität, die von einer Batterie (204) bereitgestellt wird, bestimmt ist und wobei das Hilfsmodul (118) zur Bereitstellung von Elektrizität, bezeichnet als Erregungselektrizität, für einen Rotor des Elektromotors (202) auf der Basis von der Elektrizität, die von der Batterie (204) bereitgestellt wird, bestimmt ist.

8. Elektrische Vorrichtung (114) nach einem der Ansprüche 1 bis 7, wobei das Hauptmodul (116) ein Hauptgehäuse (302) aufweist und das Hilfsmodul (118) ein Hilfsgehäuse (308) aufweist wobei die Halterung(en) (310) von dem Hauptgehäuse (302) und dem Hilfsgehäuse (308) derart getragen wird/werden, dass das Hilfsgehäuse (308) am Hauptgehäuse (302) gehalten wird.

9. Elektrisches System (100), aufweisend:
- eine elektrische Vorrichtung (114) nach einem der Ansprüche 1 bis 8,
- eine Kühlplatte (102), aufweisend einen zurückspringenden Absatz (104) und einen vorspringenden Absatz (106), der sich vor dem zurückspringenden Absatz (104) erstreckt, wobei die zwei Absätze (104, 106) durch eine Stufe (108) miteinander verbunden sind,
wobei das Hauptmodul (116) am vorspringenden Absatz (106) befestigt ist, der den ersten Halter bildet, und wobei das Hilfsmodul (118) am zurückspringenden Absatz (104) befestigt ist, der den zweiten Halter bildet.

10. Elektrisches System (100) nach Anspruch 9, wobei die Stufe (108) in der Vorn-Hinten-Richtung (Av-Ar) eine Höhe aufweist, die zwischen 5 mm und 20 mm liegt.

11. Elektrisches System (100) nach Anspruch 9 oder 10, aufweisend ein Kühlsystem (110), das bestimmt ist, unter dem vorspringenden Absatz (106) eine Kühlflüssigkeit zirkulieren zu lassen.

## Claims

1. Electrical device (114) including:
- a main module (116) for being secured to a first support (120),
- an auxiliary module (118) electrically connected to the main module (116) and configured to be fixed to a second support (122),
- at least one fastener (310) fastening the auxiliary module (118) to the main module (116) in order to prevent the auxiliary module (118) from becoming detached from the main module (116), the fastener(s) (310) allowing a clearance of the auxiliary module (118) relative to the main module (116), only along a front-back direction (Av-Ar), between a close position and a remote position of the main module (116).

2. Electrical device (114) according to claim 1, wherein the clearance is at least 0.5mm.

3. Electrical device (114) according to claim 1 or 2, wherein the clearance is at most 10mm.

4. Electrical device (114) according to any of claims 1 to 3, wherein the main module (116) has a back face, called a main back face (120), for being pressed against a part (120) of a cold plate (102) forming the first support, wherein the auxiliary module (118) has a back face, called an auxiliary back face (122), for being pressed against another part (122) of the cold plate (102) forming the second support, and wherein the auxiliary back face (122) extends backwardly of the main back face (120) over the whole clearance of the auxiliary module (118).

5. Electrical device (114) according to claim 4, wherein the auxiliary back face (122) extends backwardly of the main back face (120) by a distance between 5mm and 20mm when the auxiliary module (118) is in an intermediate position, halfway between the close and remote positions of the main module (116).

6. Electrical device according to any of claims 1 to 5, wherein the main module (116) includes a casing (302) in which air inlet openings (506) are provided, and further comprising screws for securing the main module (116) and auxiliary module (118) to their respective supports, these screws having a larger head than the air inlet openings (506).

7. Electrical device (114) according to any of claims 1 to 6, wherein the main module (116) is for supplying power, called drive power, to phases of an electric motor (202) from power supplied by a battery (204), and wherein the auxiliary module (118) is for supplying power, called excitation power, to a rotor of the electric motor (202) from power supplied by the battery (204).

8. Electrical device (114) according to any of claims 1 to 7, wherein the main module (116) includes a main casing (302), and the auxiliary module (118) includes an auxiliary casing (308) and wherein the fastener(s) (310) is/are carried by the main casing (302) and the auxiliary casing (308) so as to secure the auxiliary casing (308) to the main casing (302).

9. Electrical system (100) including:
- an electrical device (114) according to any of claims 1 to 8,
- a cold plate (102) having a recessed stage (104) and a projecting stage (106), extending frontwardly of the recessed stage (104), both stages (104, 106) being connected to each other by a step (108),
wherein the main module (116) is secured to the projecting stage (106) forming the first support and wherein the auxiliary module (118) is secured to the recessed stage (104) forming the second support.

10. Electrical system (100) according to claim 9, wherein the step (108) has a height in the front-back direction (Av-Ar) between 5mm and 20mm.

11. Electrical system (100) according to claim 9 or 10, comprising a cooling system (110) for circulating, under the protecting stage (106), a coolant.
